# DEMANDE DE BREVET EUROPEEN

(11) **EP 0 773 446 A1**
(43) Date de publication de la demande: **14.05.1997**
(21) Numéro de dépôt: 96402305.5
(22) Date de dépôt: 30.10.1996
(51) Int. Cl.: G01R 15/24

(54) **Capteur de tension rapide à isolation galvanique**

(30) Priorité: 10.11.1995 FR 9513308
(71) Demandeur: ABB CONTROL, F-69680 Chassieu (FR)
(72) Inventeur: Marciot, Denis, 69003 Lyon (FR)
(74) Mandataire: Laget, Jean-Loup

(57) **Abrégé**

Capteur de tension rapide à isolation galvanique, comportant une entrée de mesure, un amplificateur d'isolement, un amplificateur de sortie et une alimentation.

L'entrée de mesure est constituée par un pont diviseur (1) à résistances qui applique une fraction seulement de la tension d'entrée à mesurer à l'amplificateur d'isolement (2).

## Description

L'invention concerne un capteur de tension rapide à isolation galvanique.

Les capteurs de tension à isolation galvanique utilisent en général un transformateur dans lequel le flux engendré par un bobinage primaire est asservi au moyen d'un bobinage secondaire. Ces capteurs sont sujets à une dérive en fonction de la température, et le temps d'établissement du signal de sortie est long. Les performances dynamiques de ces capteurs sont limitées par l'utilisation de bobinages ayant un nombre élevé de spires.

Des appareils de mesure de tension à isolation galvanique existent, et utilisent un amplificateur d'isolement à couplage magnétique ou capacitif. Dans l'un et l'autre cas, l'adaptation de ces appareils au domaine d'application des capteurs de tension à asservissement de flux n'est pas entièrement satisfaisante. En particulier, ces appareils sont lents et il arrive qu'ils ne possèdent pas les qualités d'isolation requises.

L'un des buts de l'invention est de proposer un capteur de tension à isolation galvanique, qui présente en outre une grande rapidité de réponse.

L'invention a pour objet un capteur de tension rapide à isolation galvanique, comportant une entrée de mesure, un amplificateur d'isolement, un amplificateur de sortie et une alimentation, caractérisé en ce que l'entrée de mesure est constituée par un pont diviseur à résistances qui applique une fraction seulement de la tension d'entrée à mesurer à l'amplificateur d'isolement, et en ce que, entre les deux bornes d'entrée de l'amplificateur d'isolement, sont disposées deux résistances en parallèle ;

Selon d'autres caractéristiques de l'invention :
- à partir de chaque borne d'entrée de l'amplificateur d'isolement est disposée une ligne de résistances entre lesquelles sont prévues des bornes d'entrée ;
- en parallèle sur chaque résistance est disposée une autre résistance ;
- l'amplificateur d'isolement est un composant optoélectronique comportant un étage situé du côté haute tension et un étage situé du côté basse tension ;
- l'alimentation est à découpage et comprend un transformateur dont un secondaire est isolé pour l'alimentation de l'étage situé du côté haute tension de l'amplificateur d'isolement ;
- un autre secondaire du transformateur est non isolé pour l'alimentation de l'étage situé du côté basse tension de l'amplificateur d'isolement ;
- la tension du secondaire non isolé est prélevée pour assurer une régulation de la tension des deux secondaires ;
- pour l'adaptation à une sortie en courant, il comporte en outre un étage de puissance délivrant un courant proportionnel à la tension délivrée par l'amplificateur de sortie du capteur.

D'autres caractéristiques ressortent de la description qui suit faite avec référence aux dessins annexés dans lesquels :
- la figure 1 représente le schéma synoptique d'un exemple de réalisation d'un capteur de tension selon l'invention ;
- la figure 2 est un schéma d'un exemple de réalisation du pont diviseur du capteur de la figure 1 ;
- la figure 3 représente le schéma de principe d'une alimentation régulée tout en étant isolée ;
- la figure 4 représente le schéma électrique simplifié d'adaptation du capteur de tension de la figure 1 à une sortie en courant.

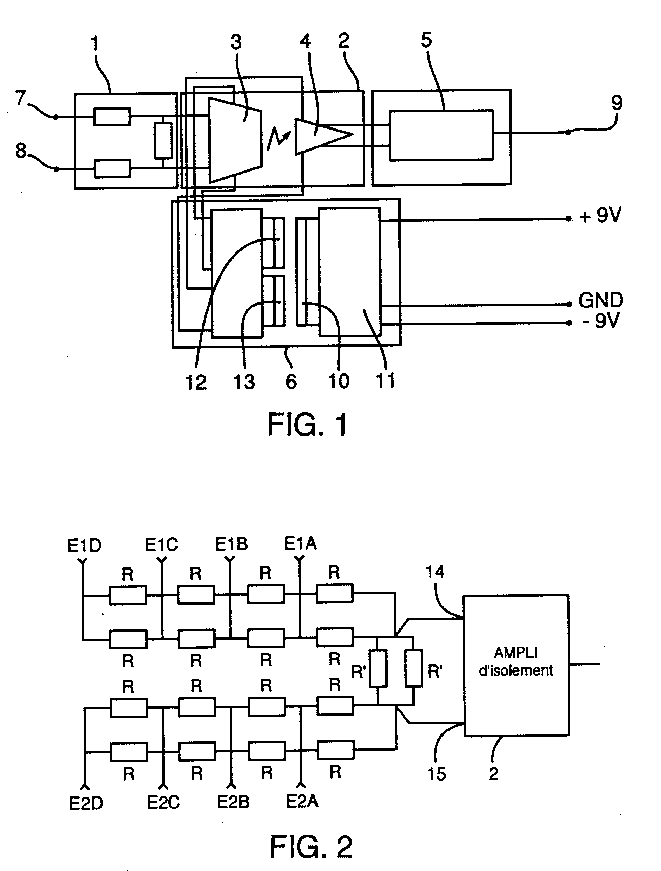

Sur la figure 1, le capteur de tension selon l'invention se compose essentiellement d'un pont diviseur 1 à résistances, d'un amplificateur d'isolement 2 comprenant un étage situé du côté haute tension 3 et un étage isolé situé du côté basse tension 4, d'un amplificateur 5 de sortie, et d'une alimentation 6.

La tension à mesurer est appliquée entre les bornes 7, 8 du pont diviseur 1 à résistances, qui prélève une fraction seulement de la tension d'entrée et l'applique à l'étage haute tension 3 de l'amplificateur d'isolement 2. Cet amplificateur d'isolement 2 est de type opto-électronique, avec une diode électro-luminescente dans l'étage haute tension 3, et un photo-transistor dans l'étage basse tension 4. Le signal d'information à basse tension en provenance de l'amplificateur d'isolement 2 est amplifié par l'amplificateur de sortie 5 et délivré en sortie de mesure 9.

L'alimentation 6 a pour objet de fournir, à partir d'une source d'alimentation continue + 9 V, - 9 V, et masse GND, une alimentation isolée pour l'étage haute tension 3 de l'amplificateur d'isolement 2, et une alimentation non isolée pour son étage basse tension 4. L'alimentation 6 est du type à découpage, à transformateur d'isolement avec un primaire 10 alimenté par un modulateur de largeur d'impulsion 11, et deux secondaires identiques 12, 13 délivrant chacun une tension continue de 5 V par exemple. Le secondaire 12 est isolé et alimente l'étage haute tension 3 de l'amplificateur d'isolement 2, le secondaire 13 est non isolé et alimente l'étage basse tension 4.

Le capteur de la figure 1 fournit à sa sortie de mesure 9, une tension proportionnelle à la tension d'entrée, dans un rapport donné, en garantissant une isolation galvanique entre l'entrée 7, 8 et la sortie 9, GND. Le capteur est utilisable dans une gamme de tensions allant par exemple de 250 V à 5000 V.

Pour couvrir cette gamme de tensions avec le même appareil, l'invention prévoit de disposer à l'entrée un pont diviseur de type particulier représenté à la figure 2. Entre les bornes d'entrée 14, 15, de l'amplificateur d'isolement 2, sont disposées en parallèle deux résistances R'. A partir de chaque borne d'entrée 14 ou 15 de l'amplificateur d'isolement 2, est disposée une ligne de résistances R, et après chaque résistance R est disposée une borne d'entrée E1 A, E1 B, ..., et E2 A, E2 B,... respectivement. Enfin, en parallèle sur chaque résistance R est disposée une autre résistance R, pour raison de sécurité.

Si les résistances R n'étaient pas doublées et que l'une soit coupée, toute la tension appliquée à l'entrée se retrouverait sur l'une des entrées de l'amplificateur d'isolement 2, ce qui pourrait détruire ce composant et entraîner la perte de l'isolation galvanique. Si, au contraire, toutes les résistances sont doublées, si l'une vient à se couper, la résistance en parallèle maintient la circulation d'un courant et empêche que toute la tension ne soit appliquée à l'une des bornes d'entrée 14, 15.

Entre les deux bornes E1 A et E2 A peut être appliquée la tension minimale de 250 V par exemple. Chaque décalage d'une des entrées E1 ou E2 correspond par exemple à un pas de 125 V. En fonction de la tension à mesurer, les entrées sont choisies, par exemple
E1 A - E2 B pour 375 V,
E1 B - E2 B pour 500 V.

Le pont diviseur 1 permet d'utiliser l'amplificateur d'isolement 2 pratiquement toujours dans la même gamme de tensions, quelle que soit la tension mesurée entre 250 et 2000 V par exemple. La tension minimale est définie entre les deux bornes d'entrée 14 et 15, et le choix des entrées s'effectue en fonction de la tension à mesurer.

Afin de réduire la puissance consommée pour l'alimentation de l'amplificateur d'isolement 2, l'alimentation utilisée est du type à découpage à haut rendement.

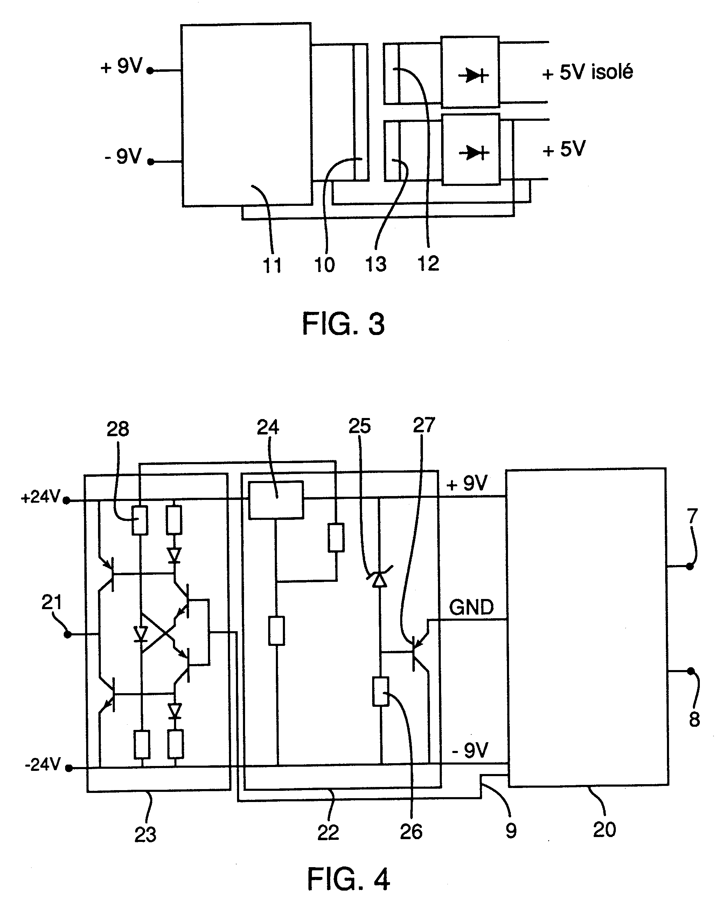

Sur la figure 3, le primaire 10 du transformateur est couplé à deux secondaires identiques 12 et 13. Le secondaire 12 délivre une tension de + 5 V isolée pour l'alimentation de l'étage haute tension 3 de l'amplificateur d'isolement 2. Le secondaire 13 délivre une tension de + 5 V non isolée pour l'alimentation de l'étage basse tension 4. Cette tension de + 5 V non isolée est prélevée et appliquée au modulateur de largeur d'impulsion 11 en vue d'une régulation.

Les deux enroulements secondaires 12 et 13 du transformateur ayant le même nombre de spires et les courants absorbés par leurs charges respectives étant identiques, les deux tensions de + 5 V sont régulées, bien que l'une des deux soit complètement isolée.

Le capteur de tension selon l'invention permet d'assurer une meilleure précision dans la mesure. En effet, il ne présente pas de dérive sensible en fonction de la température, et il ne présente que peu d'échauffement à l'entrée en raison du pont diviseur à résistances.

Le capteur de tension selon l'invention se comporte comme un transformateur tension-tension qui abaisse la tension et permet d'isoler un circuit secondaire.

Ce capteur de tension donne en sortie de mesure un signal de tension. Or les appareils du commerce qui correspondent au même objet ont une sortie en courant et une alimentation en + 24 V et - 24 V. Afin d'éviter une modification des installations en amont ou en aval du capteur, un module additionnel est prévu pour adapter au capteur une sortie en courant.

Sur la figure 4, le capteur de tension de la figure 1 est symbolisé en 20, avec ses deux entrées de mesure 7, 8, ses deux bornes d'alimentation + 9 V, - 9 V, sa borne de masse GND et sa borne de sortie de mesure en tension 9. Sur la partie gauche de la figure 4 sont représentés les trois fils des appareils classiques : deux bornes d'alimentation en + 24 V et - 24 V et une borne de sortie en courant 21. Pour assurer l'adaptation aux éléments classiques du capteur de tension 20, deux blocs sont prévus, respectivement 22 et 23.

Le bloc 22 comporte essentiellement un régulateur de tension 24 pour abaisser la tension de ± 24 V à ± 9 V, et un circuit à diode Zener 25 et résistance 26 pour contrôler un transistor 27 afin de créer une masse virtuelle. En effet, la masse du ± 24 V n'est pas au même potentiel que la masse du ± 9 V. Le capteur de tension 20 va donc délivrer un signal de sortie décalé par rapport au ± 24 V.

Le bloc 23 est un étage de puissance susceptible de délivrer un courant proportionnel à la tension de sortie du capteur de tension 20. Pour pouvoir commander le bloc 23, il faut que son étage d'entrée puisse être commandé indépendamment de la référence de son alimentation ± 24 V. Cette commande est réalisée par l'intermédiaire de la résistance 28 qui est branchée à la sortie du régulateur 24, et par le premier étage à transistor du bloc 23.

Ainsi, le capteur de tension selon l'invention peut être mis en remplacement d'appareils existants sans modification des installations amont ou aval.

Par rapport aux appareils connus, le capteur de tension selon l'invention se distingue par des performances au niveau de la bande passante par exemple, qui est de l'ordre de 40 à 50 KHz, au niveau de la rapidité de réponse, et au niveau de la sécurité d'entrée en raison du pont diviseur à résistances.

## Revendications

1. Capteur de tension rapide à isolation galvanique, comportant une entrée de mesure, un amplificateur d'isolement, un amplificateur de sortie et une alimentation, caractérisé en ce que l'entrée de mesure est constituée par un pont diviseur (1) à résistances qui applique une fraction seulement de la tension d'entrée à mesurer à l'amplificateur d'isolement (2), et en ce que, entre les deux bornes d'entrée (14, 15) de l'amplificateur d'isolement (2), sont disposées deux résistances (R') en parallèle.

2. Capteur selon la revendication 1, caractérisé en ce que à partir de chaque borne d'entrée (14, 15) de l'amplificateur d'isolement (2) est disposée une ligne de résistances (5) entre lesquelles sont prévues des bornes d'entrée (E1 A, E1 B, E2 A, E2 B,...).

3. Capteur selon la revendication 2, caractérisé en ce que en parallèle sur chaque résistance (R) est disposée une autre résistance (R).

4. Capteur selon la revendication 1, caractérisé en ce que l'amplificateur d'isolement (2) est un composant optoélectronique comportant un étage situé du côté haute tension (3) et un étage situé du côté basse tension (4).

5. Capteur selon la revendication 4, caractérisé en ce que l'alimentation est à découpage et comprend un transformateur dont un secondaire (12) est isolé pour l'alimentation de l'étage situé du côté haute tension (3) de l'amplificateur d'isolement (2).

6. Capteur selon la revendication 5, caractérisé en ce que un autre secondaire (13) du transformateur est non isolé pour l'alimentation de l'étage situé du côté basse tension (4) de l'amplificateur d'isolement (2).

7. Capteur selon la revendication 6, caractérisé en ce que la tension du secondaire non isolé (13) est prélevée pour assurer une régulation de la tension des deux secondaires (12, 13).

8. Capteur selon la revendication 1, caractérisé en ce que pour l'adaptation à une sortie en courant, il comporte en outre un étage de puissance délivrant un courant proportionnel à la tension délivrée par l'amplificateur de sortie du capteur (20).
